# EUROPÄISCHE PATENTSCHRIFT

(11) **EP 3 314 709 B1**
(45) Veröffentlichungstag und Bekanntmachung des Hinweises auf die Patenterteilung: **04.11.2020**
(21) Anmeldenummer: 16731905.2
(22) Anmeldetag: 24.06.2016
(51) Int. Cl.: H02H 3/16, H02H 5/12, G01R 31/52, G01R 27/18

(54) **DETEKTOR ZUM ERKENNEN EINES ERD / FEHLERSTROMES**
DETECTOR FOR RECOGNIZING A GROUND / FAULT CURRENT
DÉTECTEUR POUR DÉTECTER UN COURANT DE FUITE/PERTE

(30) Priorität: 24.06.2015 DE 102015110108
(43) Veröffentlichungstag der Anmeldung: 02.05.2018
(73) Patentinhaber: Eaton Intelligent Power Limited, Dublin 4 (IE)
(72) Erfinder: HASLINGER, Stefan, 2522 Oberwaltersdorf (AT)
(74) Vertreter: Eaton IP Group EMEA
(86) Internationale Anmeldenummer: PCT/EP2016/064632
(87) Internationale Veröffentlichungsnummer: WO 2016/207326

(56) Entgegenhaltungen:
- EP-A1- 0 348 128
- WO-A1-89/11747
- WO-A1-2013/092815
- US-A- 5 003 486
- US-A1- 2009 251 839
- US-A1- 2012 206 148

## Beschreibung

Die Erfindung betrifft einen Detektor gemäß dem Gattungsbegriff des Patentanspruches 1.

Es sind Detektoren zum Erkennen eines Erd-Fehlerstromes bzw. eines Differenzstromes bekannt. In der Regel sind derartige Detektoren Teil eines Fehlerstromschutzschalters. Überschreitet ein Erd-Fehlerstrom einen gewissen Wert löst der betreffende Fehlerstromschutzschalter nach einer gewissen Zeitspanne aus, und öffnet Schaltkontakte desselben um einen nachgeschalteten elektrischen Kreis vom restlichen Energieversorgungsnetz zu trennen.

Es hat sich gezeigt, dass es in einem elektrischen AC- oder DC-Netz zu einem Erdstrom, Fehlerstrom, Ableitstrom bzw. Differenzstrom kommen kann, bei welchen ein Mensch als elektrisch ableitender Teil fungiert, welcher Erd-Fehlerstrom derart kurzzeitig ist, dass es zu keinem Auslösen der betreffenden Schutzvorrichtung bzw. des Fehlerstromschutzschalters kommt. Weiters kann es passieren, dass bei einem derartigen Erd-Fehlerstrom, insbesondere wenn es sich um Gleichstrom handelt, ein Schutzschalter erst sehr spät bis gar nicht auslöst, da die entsprechende Stromschwelle des Fehlerstromschutzschalters nicht erreicht wird.

Bei einem kurzzeitigen Erd-Fehlerstrom wird der Stromfluss in der Regel durch eine Muskelkontraktion des betroffenen Menschen aufgrund des Stromflusses unterbrochen: Der Mensch zuckt zurück, und der Erd-Fehlerstrom ist wieder beendet bevor es aufgrund der Zeitdauer oder der Stromstärke zu einem Auslösen des Fehlerstromschutzschalters kommt. Je nach Höhe eines Körperstromes und der Zeitdauer des Erd-Fehlerstroms kann es jedoch auch nach Beendigung der Stromdurchflutung noch zu schwerwiegenden Folgen beim Menschen kommen, weshalb bei Elektro-Unfällen, bei welchen Menschen vom elektrischen Strom durchflossen wurden, die betroffenen Menschen in der Regel für kurze Zeit unter ärztlicher Aufsicht gehalten werden sollten. Derartige Spätfolgen treten insbesondere bei Gleichstrom auf. Da jedoch bei besagten Unfällen der betreffende Stromkreis nicht abgeschaltet wird, sowie in Ermangelung aussagekräftiger Messergebnisse, halten die Betroffenen derartige Unfälle für harmlos, und begeben sich in der Regel nicht in ärztliche Obhut, wodurch es für die Betroffenen zu Folgeschäden bis hin zum Tod kommen kann.

Weiters wurde beobachtet, dass in gewissen elektrischen Netzen Erd/Fehlerströme über Menschen auftreten können, welche derart hoch sind, dass bis zum regulären Ansprechen des Fehlerstromschutzschalters mit einer Schädigung des Betroffenen gerechnet werden muss. Die dabei auftretenden Erd-Fehlerströme sind jedoch bei weitem nicht hoch genug um ein Auslösen eines Kurzschlussauslösers eines Leitungsschutzschalters zu verursachen.

Die US 5 003 486 A, die den nächstliegenden Stand der Technik widerspiegelt, beschreibt eine programmierbare Überwachungseinheit zur Kontrolle des Betriebes einer elektrischen Sicherheitssteckdose, wobei zwischen einer elektrischen Last und einem Fehler durch Kontakt mit einem Menschen unterschieden wird.

Die WO 89/11747 A1 beschreibt eine elektrische Sicherheitseinrichtung zur schaltungstechnischen Anordnung zwischen einer elektrischen Quelle und einer Last, wobei die Sicherheitseinrichtung dazu vorgesehen ist vor einem elektrischen Schlag zu schützen, etwa wenn eine Nadel in eine Steckdose eingeführt wird.

Die US 2009/251839 A1 beschreibt eine Vorrichtung zum Schutz vor elektrischen Schlägen bei elektrischen Hochspannungsquellen.

Bei einem Impedanzmessgerät gemäß der WO 2013/092815 A1 ist vorgesehen eine Schleifenimpedanz eines elektrischen Netzes zu ermitteln, wobei das Impedanzmessgerät elektrische Anschlüsse und eine Impedanzmessanordnung aufweist, und das Impedanzmessgerät zur Anordnung im Bereich eines elektrischen Schutzschalters ausgebildet ist.

Aus der EP 348 128 A1 geht ein elektrischer Auslass hervor, welcher automatisch zwischen einem menschlichen oder tierischen Kontakt oder einem Anschluss eines elektrischen Geräts unterscheidet.

Die US 2012/206148 A1 beschreibt eine Vorrichtung sowie ein entsprechendes Verfahren zur Bestimmung eines maximalen Leckstromes in einem nicht geerdeten elektrischen Versorgungsnetz mit einer Vielzahl an Verbindungen.

Aufgabe der Erfindung ist es daher einen Detektor der eingangs genannten Art anzugeben, mit welchem die genannten Nachteile vermieden werden können, mit welchem Menschen besser vor den unmittelbaren und mittelbaren Wirkungen des elektrischen Stromes geschützt werden können.

Erfindungsgemäß wird dies durch die Merkmale des Patentanspruches 1 erreicht. Dadurch kann erkannt werden, ob ein Erd-Fehlerstrom durch einen Menschen verursacht wurde, und nachfolgend entsprechend angepasste Maßnahmen ergriffen werden. Dadurch können Fehler erkannt, protokolliert und gemeldet werden, welche nicht zu einem Auslösen eines Fehlerstromschutzschalters führten, da diese zuvor bereits wieder beendet waren. Dadurch können elektrische Fehlstellen beseitigt werden. Dadurch kann bei einem elektrischen Fehler, bei dem ein Mensch leitender Teil war, die Stärke der Belastung des betreffenden Menschen festgestellt werden. Unabhängig vom Auslösen eines Schutzschalters kann eine Warnmeldung, eventuell verbunden mit dem Hinweis einen Arzt aufzusuchen, abgegeben werden. Dadurch kann auch unmittelbar bzw. automatisiert medizinische Hilfe angefordert werden. Dadurch kann bei einem schwerwiegenden Erd-Fehlerstrom ein angeschlossener Schutzschalter bereits früher bzw. schneller aktiviert werden, als dies durch die einschlägigen Normen vorgegeben ist. Dadurch kann das Leben von Menschen besser gegen die Wirkungen des elektrischen Stromes geschützt werden. Dadurch kann ein Mensch auch vor den nicht unmittelbaren und nicht direkten Auswirkungen des elektrischen Stromes geschützt werden. Dadurch können auf der anderen Seite unnötige Netzabschaltungen verhindert werden, da genauer zwischen Fehlern von gesundheitsgefährdender Stärke unterschieden werden kann, bei welchen Menschen beteiligt sind, und eine entsprechende Reaktion erforderlich ist, und reinen Anlagefehlern.

Die Erfindung betrifft weiters ein Verfahren gemäß dem Patentanspruch 5.

Aufgabe der Erfindung ist es daher ein Verfahren der vorstehend genannten Art anzugeben, mit welchem die eingangs genannten Nachteile vermieden werden können, mit welchem Menschen besser vor den unmittelbaren und mittelbaren Wirkungen des elektrischen Stromes geschützt werden können.

Erfindungsgemäß wird dies durch die Merkmale des Patentanspruches 5 erreicht.

Dadurch können die vorstehend zum Patentanspruch 1 geltend gemachten Vorteile erzielt werden.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 ein Blockschaltbild einer Ausführungsform eines gegenständlichen Detektors;
Fig. 2 ein Blockschaltbild einer ersten Ausführungsform eines gegenständlichen Schaltgeräts mit einem gegenständlichen Detektor; und
Fig. 3 ein Blockschaltbild einer zweiten Ausführungsform eines gegenständlichen Schaltgeräts mit einem gegenständlichen Detektor.

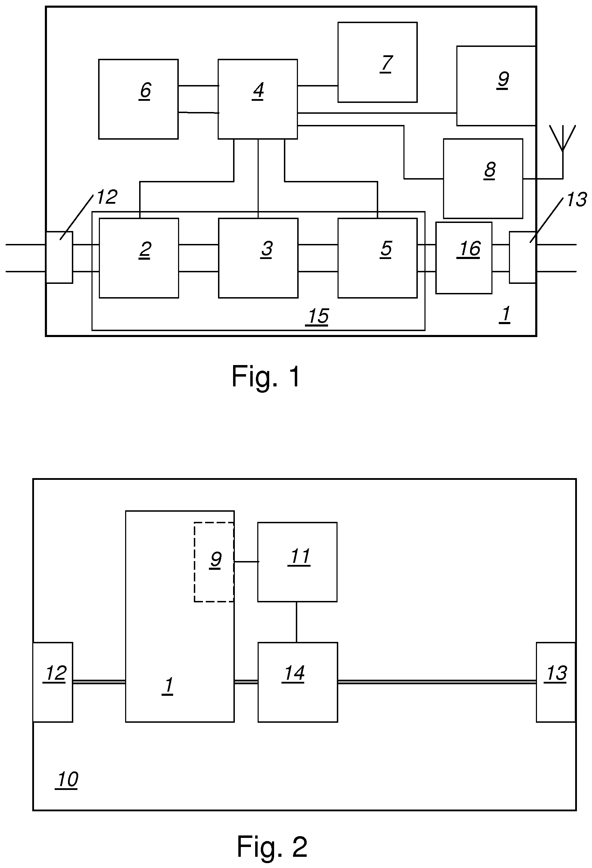

Die Fig. 1 zeigt einen Detektor 1 zum Erkennen eines Erd/Fehlerstromes als durch einen Menschen und/oder ein vorgebbares Nutztier verursachten Erd/Fehlerstrom innerhalb eines elektrischen Kreises, wobei der Detektor 1 wenigstens eine Erd/Fehlerstrom-Impedanzmessanordnung 15 aufweist, wobei der Detektor 1 eine Vergleichs- und Entscheidungseinheit 4 aufweist, welche Vergleichs- und Entscheidungseinheit 4 mit der Impedanzmessanordnung 15 verbunden ist, wobei die Vergleichs- und Entscheidungseinheit 4 dazu ausgebildet ist, ermittelte Werte der Erd/Fehlerstrom-Impedanz mit wenigstens einer vorgebbaren Erd/Fehlerstrom-Impedanz-Grenzbedingung zu vergleichen, wobei die Vergleichs- und Entscheidungseinheit 4 weiters dazu ausgebildet ist, den Erd/Fehlerstrom als menschenverursachten Erd/Fehlerstrom auszugeben, wobei zur Ausgabe des Erd-Fehlerstroms als menschenverursachten Erd-Fehlerstrom die Erd/Fehlerstrom-Impedanz die wenigstens eine Erd/Fehlerstrom-Impedanz-Grenzbedingung erfüllen muss.

Dadurch kann erkannt werden, ob ein Erd-Fehlerstrom durch einen Menschen bzw. eine bestimmte Nutztierart verursacht wurde, und nachfolgend entsprechend angepasste Maßnahmen ergriffen werden. Dadurch können Fehler erkannt, protokolliert und gemeldet werden, welche nicht zu einem Auslösen eines Fehlerstromschutzschalters führten, da diese zuvor bereits wieder beendet waren. Dadurch können elektrische Fehlstellen beseitigt werden. Dadurch kann bei einem elektrischen Fehler, bei dem ein Mensch leitender Teil war, die Stärke der Belastung des betreffenden Menschen festgestellt werden. Unabhängig vom Auslösen eines Schutzschalters kann eine Warnmeldung, eventuell verbunden mit dem Hinweis einen Arzt aufzusuchen, abgegeben werden. Dadurch kann auch unmittelbar bzw. automatisiert medizinische Hilfe angefordert werden. Dadurch kann bei einem schwerwiegenden Erd/Fehlerstrom ein angeschlossener Schutzschalter bereits früher bzw. schneller aktiviert werden, als dies durch die einschlägigen Normen vorgegeben ist. Dadurch kann das Leben von Menschen besser gegen die Wirkungen des elektrischen Stromes geschützt werden. Dadurch kann ein Mensch auch vor den nicht unmittelbaren und nicht direkten Auswirkungen des elektrischen Stromes geschützt werden. Dadurch können auf der anderen Seite unnötige Netzabschaltungen verhindert werden, da genauer zwischen Fehlern von gesundheitsgefährdender Stärke unterschieden werden kann, bei welchen Menschen beteiligt sind, und eine entsprechende Reaktion erforderlich ist, und reinen Anlagefehlern.

Es bestehen Unterschiede hinsichtlich dem Impedanzverhalten zwischen Menschen und unterschiedlichen Nutztieren. Bevorzugt ist vorgesehen, dass der gegenständliche Detektor 1 für eine vorgebbare und eingeschränkte Gruppe von Nutztieren vorgesehen ist, beispielsweise Rinder, Schweine, Schafe, Hunde und/oder Katzen. Bei typischen Berührungsspannungen von 230V bis 240V weist ein Mensch eine Impedanz um die 600 Ohm auf, während bei den angesprochenen Nutztieren, die Körperimpedanzen unter 300 Ohm liegen. Bevorzugt ist daher vorgesehen, dass am Detektor 1 selbst eine Auswahl durch einen Benutzer getroffen werden kann, bei welcher die Art der Nutztiere im Überwachungsbereich des Detektors 1 vorgegeben wird. Dabei kann auch vorgesehen sein, dass der Detektor 1 einen beschreibbaren Speicher und eine Schnittstelle aufweist, um zusätzliche Daten weiterer Nutztiere dem Detektor 1 zuzuführen.

Ein gegenständlicher Detektor 1 kann als eigenständige Einheit ausgebildet sein, welche für sich in einem elektrischen Netz angeordnet werden kann. Dabei kann der betreffende Detektor 1, an der jeweils vorgesehen Stelle innerhalb des Netzes, dieses auf das Auftreten von Fehlerströmen bzw. Erd-Fehlerströmen bzw. Differenzströmen überwachen, welche durch Menschen und/oder vorgebbare Nutztiere direkt verursacht wurden, und beim Auftreten entsprechender Fehlerströme eine Warnmeldung erzeugen und anzeigen bzw. absetzen.

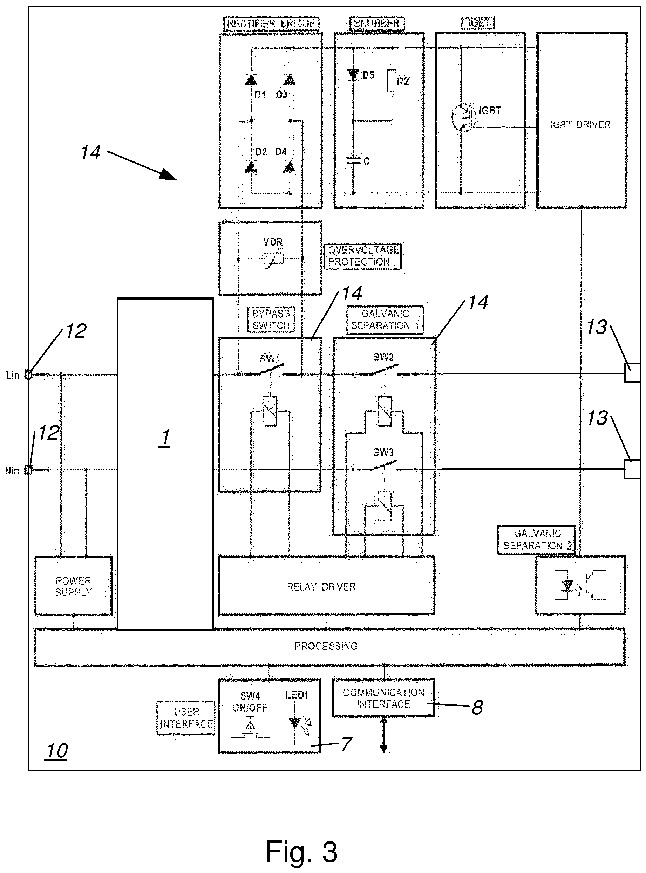

Bevorzugt ist vorgesehen, dass der gegenständliche Detektor 1 als integraler Bestandteil eines Schaltgeräts 10 ausgebildet ist. Das betreffende Schaltgerät 10 weist dabei in an sich bekannter Weise eine Leitungsunterbrechungsvorrichtung 14 auf. Die Leitungsunterbrechungsvorrichtung 14 kann mittels rein mechanischer Trennkontakte ausgebildet sein, wobei jedoch bevorzugt vorgesehen ist, dass die Leitungsunterbrechungsvorrichtung 14 als hybride Schaltvorrichtung, umfassend Halbleiterschalter sowie mechanische Bypasskontakte ausgebildet ist. Fig. 3 zeigt ein Blockschaltbild eines derartig ausgebildeten Schaltgeräts 10.

Der Detektor 1 weist Anschlussklemmen 12, 13 zum Anschluss der Leiter eines elektrischen Netzes auf. Dabei ist vorgesehen, dass an den Detektor1 wenigstens eine stromführende Phase L sowie ein Neutralleiter N angeschlossen werden. Bei Ausbildung des Detektors 1 als Teil eines Schaltgeräts 10 sind die Anschlussklemmen 12, 13 des Detektors 1 durch die Anschlussklemmen 12, 13 des Schaltgeräts 10 gebildet.

Bei der im weiteren Verlauf beschriebenen besonders bevorzugten Ausführungsform eines gegenständlichen Detektors 1 ist vorgesehen, dass zwischen netzseitigen bzw. versorgungsseitigen Anschlussklemmen 12 und lastseitigen bzw. ausgangsseitigen Anschlussklemmen 13 unterschieden wird.

Der Detektor 1 weist mehrere Messanordnungen zum Messen physikalischer Größen auf. Die nachfolgend beschriebenen Messanordnungen können dabei jeweils separat ausgebildet sein, es kann jedoch auch vorgesehen sein, dass einzelne Baugruppen von zwei oder mehr Messanordnungen synergistisch benutzt werden.

Gegenständlichen wird der Begriff Erd/Fehlerstrom verwendet, wobei jegliche Art eines Fehlerstromes mitumfasst ist, daher Erdfehlerströme, Differenzströme, Ableitströme und sonstige Fehlströme bzw. Fehlerströme.

Der Detektor 1 weist eine Erd/Fehlerstrom-Impedanzmessanordnung 15 auf, zum Messen einer Impedanz einer Fehlerstelle.

Gemäß den bevorzugten Ausführungsformen ist vorgesehen, dass die Erd/Fehlerstrom-Impedanzmessanordnung 15 eine Spannungsmessanordnung 2 zum Messen einer, an dem elektrischen Kreis anliegenden, Versorgungsspannung aufweist, welche Versorgungsspannung an dem Detektor 1 bzw. dem diesem nachgeschalteten elektrischen Kreis anliegt. Die Spannungsmessanordnung 2 kann dabei in bekannter Weise ausgebildet sein.

Die Erd/Fehlerstrom-Impedanzmessanordnung 15 weist weiters bevorzugt eine Erd/Fehlerstrommessanordnung 3 auf, um im Falle eines auftretenden Erd-Fehlerstromes einen solchen zu erfassen und zu Messen. Die Erd-Fehlerstrommessanordnung 3 kann dabei in bekannter Weise ausgebildet sein. Dabei ist neben der weit verbreiteten Ausbildung der Erd-Fehlerstrommessanordnung 3 umfassend einen Summenstromwandler weiters vorgesehen, die Ströme in den einzelnen Leitern separat zu Messen, etwa mittels einzelner Messwandler oder mittels Shunt-Widerständen, und nachfolgend mathematisch eine Summenbildung der einzelnen Ströme in den einzelnen Leitern L, N vorzunehmen.

Gegenständlich ist vorgesehen die Impedanz einer Fehlerstelle zu ermitteln. Dabei ist bevorzugt vorgesehen, wenigstens einen Wert für diese sog. Erd/Fehlerstrom-Impedanz bzw. Erdschlussimpedanz zu ermitteln, und diesen betreffenden Wert mit wenigstens einem Grenzwert zu vergleichen. Aufgrund der speziellen Eigenarten des Körpers eines Menschen bzw. der üblichen Nutztiere, ist bekannt, dass diese nur eine geringe Phasendrehung verursachen, sollten deren Körper von Strom durchflossen werden. Es kann daher in einer einfachen Ausgestaltung der gegenständlichen Erfindung vorgesehen sein, lediglich einen Realteil der betreffenden Erd/Fehlerstrom-Impedanz zu ermitteln, welcher dann mit lediglich einem Grenzwert verglichen werden kann.

Die Erd/Fehlerstrom-Impedanz kann aus einem Wert der Versorgungsspannung bzw. einer Ausgangsspannung des Detektors 1, sowie einem Wert für den Erd/Fehlerstrom ermittelt werden. Der betreffende Zusammenhang ist aus dem ohmschen Gesetzt bekannt. Dabei kann die unvollständige Ermittlung der Erd/Fehlerstrom-Impedanz im Rahmen der Erfindung als ausreichend erachtet werden, indem kein Wert für die Erd/Fehlerstrom-Impedanz ermittelt und verglichen wird, sondern ein Wertepaar für die Ausgangsspannung und den Erd/Fehlerstrom, welche beiden Werte jeweils mit Grenzwerten verglichen werden. Aus der Höhe der Netzspannung sowie der Höhe eines Erd-Fehlerstromes kann bereits ein deutlicher Rückschluss auf die Art der Fehlerursache getätigt werden. Wenn dabei bei stabiler Netzspannung ein Strom fließt, welcher durch eine, für den Menschen typische, Impedanz bedingt ist, kann mit hoher Wahrscheinlichkeit darauf geschlossen werden, dass der betreffende elektrische Fehler durch den Kontakt eines Menschen mit dem elektrischen Netz verursacht wurde.

Der Detektor 1 weist eine Vergleichs- und Entscheidungseinheit 4 auf, welche Vergleichs- und Entscheidungseinheit 4 mit der Erd/Fehlerstrom-Impedanzmessanordnung 15 verbunden ist.

Es ist vorgesehen, dass die Vergleichs- und Entscheidungseinheit 4 dazu ausgebildet ist, ermittelte Werte der Erd/Fehlerstrom-Impedanz mit wenigstens einer vorgebbaren Erd/Fehlerstrom-Impedanz-Grenzbedingung zu vergleichen. Dabei kann auch vorgesehen sein, dass die Vergleichs- und Entscheidungseinheit 4 dazu ausgebildet ist, ermittelte Werte der Netzspannung mit vorgebbaren Spannungs-Grenzbedingungen, sowie ermittelte Werte des Erd/Fehlerstromes mit vorgebbaren Erd/Fehlerstrom-Grenzbedingungen zu vergleichen.

Die Vergleichs- und Entscheidungseinheit 4 ist weiters dazu ausgebildet, den Erd/Fehlerstrom als menschenverursachten Erd/Fehlerstrom auszugeben, wobei zur Ausgabe des Erd-Fehlerstroms als menschenverursachten Erd-Fehlerstrom die Erd/Fehlerstrom-Impedanz die wenigstens eine Erd/Fehlerstrom-Impedanz-Grenzbedingung erfüllen muss. Im Falle eines Vergleiches der gemessenen Versorgungsspannung sowie des Erd/Fehlerstromes mit den jeweiligen Grenzbedingungen, ist bevorzugt vorgesehen, dass diese jeweils mit den entsprechenden Grenzbedingungen verglichen werden, wobei die beiden Grenzbedingungen bzw. deren Erfüllen logisch "UND" verknüpft sind.

Die betreffenden Grenzbedingungen sind jeweils bevorzugt als Grenzwertepaar ausgebildet, daher aus einem unteren Grenzwert sowie einem oberen Grenzwert.

Sofern eine Zuordnung eines Fehlerstrom-Ereignises auf den leitenden Kontakt mit einem Menschen bzw. einem Nutztier erfolgt ist, ist vorgesehen, den Erd-Fehlerstrom als menschenverursachten Erd-Fehlerstrom auszugeben. Auszugeben bedeutet dabei insbesondere, dass ein Schaltgerät 10 angesteuert wird, um gegebenenfalls die Kontakte zu trennen, sowie dass vorzugsweise eine Nachricht erzeugt und ausgegeben wird. Eine derartige Nachricht kann etwa in Form eines Signaltons, einer Anzeigelampe oder einer komplexeren Nachricht innerhalb eines Telekommunikationsnetzwerkes ausgegeben werden.

Die Vergleichs- und Entscheidungseinheit 4 ist bevorzugt umfassend einen Mikrokontroller ausgebildet, wobei auch ein voll- oder teildiskreter Aufbau vorgesehen sein kann.

Bevorzugt ist vorgesehen, dass der Detektor 1 eine Phasen-Messanordnung 5 aufweist, welche zum Ermitteln eines Phasenwinkels zwischen der Versorgungsspannung und dem Erd-Fehlerstrom ausgebildet ist. Die Vergleichs- und Entscheidungseinheit 4 ist mit der Phasen-Messanordnung 5 verbunden. Entsprechend ist bei einem Detektor 1, welcher eine entsprechende Phasen-Messanordnung 5 aufweist, vorgesehen, dass die Vergleichs- und Entscheidungseinheit 4 dazu ausgebildet ist, den Phasenwinkel mit Phasenwinkel-Grenzbedingungen zu vergleichen, und den Erd/Fehlerstrom nur dann als menschenverursachten Erd/Fehlerstrom auszugeben, wenn weiters auch die Phasenwinkel-Grenzbedingungen durch den Phasenwinkel erfüllt sind. Der Phasenwinkel bzw. das Erfüllen des Phasenwinkel-Grenzbedingung sind daher mit der wenigstens einen anderen Grenzbedingung logisch "UND" verknüpft. Bevorzugt ist die Phasen-Messanordnung 5 Teil der Erd/Fehlerstrom-Impedanzmessanordnung 15.

Es hat sich gezeigt, dass die durch einen Menschen im direkten Stromfluss verursachte Phasenverschiebung leicht kapazitiv ist, und bei Berührungsspannungen von ca. 240V etwa 4° bis 6° beträgt. Bei Berührungsspannungen von ca. 110V beträgt die entsprechende Phasenverschiebung etwa 9° bis 11°. Durch die zusätzliche Bestimmung des Phasenwinkels kann somit noch genauer bestimmt werden, ob der betreffende Erd-Fehlerstrom durch einen menschlichen Kontakt verursacht wurde.

Es hat sich gezeigt, dass auch die Körperimpedanz eines Menschen von der Höhe der Berührungsspannung und weiters von der Zeitdauer des Stromflusses abhängig ist. Bei einer Berührungsspannungen von ca. 240V beträgt der Anfangskörperwiderstand etwa 550 Ω bis 600 Ω, welcher nachfolgend auf Werte um etwa 1 kΩ ansteigt.

Es hat sich dabei als besonders vorteilhaft erwiesen, beim Auftreten eines Erd-Fehlerstromes dessen zeitlichen Verlauf bzw. dessen instationäres Anfangsverhalten oder auch "Einschwingen" zu messen und bei der Bewertung zu berücksichtigen. Es hat sich gezeigt, dass beim Menschen im direkten Stromfluss typische Effekte auftreten und messbar sind. So kommt es etwa zu einem anfänglichen Durchschlagen der Haut als Isolierschicht, sofern die Spannung ausreichend hoch ist, sowie zu typischen Stromverläufen über die erste Zeit des Stromflusses. Typische Einschwingvorgänge am Menschen im direkten Stromfluss erfolgen in der Regel innerhalb von ca. einer Millisekunde.

Es hat sich weiters gezeigt, dass die Impedanz eines Körpers je nach Höhe der an einem Menschen bzw. einem Nutztier anliegenden Spannung stark variiert. Dabei zeigen die unterschiedlichen Werte in deren Relation zueinander ein typisches Muster, und dies unabhängig von den exakten Werten einer Körperimpedanz.

Es ist bevorzugt vorgesehen, dass der Detektor 1 eine Spannungsanpassungseinheit 16 zur vorgebbaren Anpassung, insbesondere Absenkung, einer Ausgangsspannung des Detektors 1 gegenüber der Versorgungsspannung aufweist. Dadurch kann die an der Fehlerstelle anliegende Spannung kurzzeitig variiert werden, wodurch Messwerte bei unterschiedlichen anliegenden Spannungen aufgenommen werden können. Dadurch kann das spannungsabhängige Verhalten der Körperimpedanz eines Menschen bzw. eines Nutztieres ausgewertet werden, wodurch eine genauere Detektion eines Menschen bzw. Nutztieres möglich ist.

Weiters konnte beobachtet werden, dass die Körperimpedanz weiters stark frequenzabhängig ist. Dabei führt eine ansteigende Frequenz bei ansonsten unveränderter Spannung zu einem Absinken der Körperimpedanz eines Menschen bzw. eines Nutztieres.

Es ist weiters bevorzugt vorgesehen, dass die Spannungsanpassungseinheit 16 zur vorgebbaren Anpassung, insbesondere zur Verdoppelung, einer Frequenz der Ausgangsspannung gegenüber der Versorgungsspannung ausgebildet ist. Die Spannungsanpassungseinheit 16 passt daher nicht nur den Wert der Spannung an, sondern, ähnlich einer elektrischen Laborspannungsquelle, auch die Frequenz derselben.

Gemäß einer bevorzugten Ausführungsform der gegenständlichen Erfindung ist daher vorgesehen, dass die Spannungsanpassungseinheit 16 dazu ausgebildet ist,
- in einem ersten Schritt die Ausgangsspannung auf einen ersten Spannungswert kleiner 10% der Versorgungsspannung abzusenken, bei, gegenüber der Versorgungsspannung, unveränderter Frequenz der Ausgangsspannung,
- in einem zweiten Schritt die Ausgangsspannung auf dem ersten Spannungswert zu belassen, und die Frequenz der Ausgangsspannung gegenüber der Versorgungsspannung zu verdoppeln,
- in einem dritten Schritt, bei, gegenüber der Versorgungsspannung verdoppelter Frequenz, die Ausgangsspannung auf einen zweiten Spannungswert zwischen 25% und 50% der Versorgungsspannung einzustellen, und
- in einem vierten Schritt die Ausgangsspannung auf dem zweiten Spannungswert zu belassen, und die Frequenz der Ausgangsspannung an die Frequenz der Versorgungsspannung anzugleichen.

Bevorzugt ist vorgesehen, dass im ersten Schritt die Ausgangsspannung auf einen Wert um die 10 V abgesenkt wird, dass die Frequenz im zweiten Schritt von 50 Hz bzw. 60 Hz auf 100 Hz bzw. 120 Hz erhöht wird, und dass im dritten Schritt die Ausgangsspannung auf einen Wert um die 50 V eingestellt wird.

Dabei wird zu jedem der vier Schritte, welche selbstverständlich auch in anderer Reihenfolge durchgeführt werden können, jeweils eine Erd/Fehlerstrom-Impedanz ermittelt bzw. gemessen. Die ermittelten Werte können dann jeweils mit einer Erd/Fehlerstrom-Impedanz-Grenzbedingung verglichen werden. Bevorzugt ist jedoch vorgesehen, jeweils wenigstens zwei der vier Werte für die Erd/Fehlerstrom-Impedanz in Relation zueinander zu setzen, und den derart ermittelten einheitenlosen Verhältniswert mit einer entsprechend einheitenlosen Erd/Fehlerstrom-Impedanz-Grenzbedingung zu vergleichen.

Es ist bevorzugt vorgesehen, dass die einzelnen Messanordnungen 2, 3, 5 aufzunehmende Messwerte mit wenigstens 8kHz abtasten, bzw. bei analogen Messanordnungen, dass diesen ein entsprechender Analog/Digitalwandler nachgeschaltet ist.

Weiters hat es sich als vorteilhaft gezeigt, die Zeitdauer eines Erd-Fehlerstromes aufzunehmen und in die Entscheidung hinsichtlich dem Detektieren eines menschlichen Erdschlusses mit einfließen zu lassen. Gelangt ein Mensch in einen Stromfluss kann es aufgrund einer unkontrollierten Muskelkontraktion als Folge des Stromflusses zu einer schnellen Unterbrechung des Stromflusses kommen. Die zeitliche Dauer derartiger Muskelkontraktionen kann dabei empirisch bestimmt werden. Es ist daher weiters bevorzugt vorgesehen, dass der Detektor 1 eine Uhr 6 zum Messen der Dauer des Erd-Fehlerstromes aufweist, welche mit der Vergleichs- und Entscheidungseinheit 4 verbunden ist. Die Vergleichs- und Entscheidungseinheit 4 ist entsprechend dazu ausgebildet, die Dauer des Erd-Fehlerstromes mit wenigstens einer vorgebbaren Zeit-Grenzbedingung zu vergleichen, und bei Überschreiten der wenigstens einen Zeit-Grenzbedingung durch einen menschenverursachten Erd-Fehlerstrom diesen als für den Menschen gefährlichen Erd-Fehlerstrom auszugeben. Neben der Ausgabe des Erd-Fehlerstromes als gefährlichen Erd-Fehlerstrom kann eben auch ein sehr kurzer Erd-Fehlerstrom sicher erkannt und einem Menschen als Ursache zugeordnet werden.

Es sei darauf hingewiesen, dass die einzelnen Baugruppen des gegenständlichen Detektors 1 auch weiter separiert werden können. So können etwa die Aufgaben der Vergleichs- und Entscheidungseinheit 4 auf mehrere Teileinheiten verteilt werden, welche etwa mittels sequenzieller Logikschaltungen miteinander verbunden sind. Weiters können auch weitere Messanordnungen vorgesehen sein. Es kann auch vorgesehen sein, die Aufgaben bzw. Funktionen der Vergleichs- und Entscheidungseinheit 4 in die jeweiligen Messanordnungen zu verlagern.

Der Detektor 1 weist entsprechend einer bevorzugten Ausführungsform eine Anzeigeeinheit 7 zur Anzeige einer Statusmeldung und/oder einer Warnmeldung auf. Die betreffende Anzeigeeinheit 7 ist mit der Vergleichs- und Entscheidungseinheit 4 verbunden. Bevorzugt ist die Anzeigeeinheit 7 als akustischer Signalgeber und/oder optische Anzeige ausgebildet. Mittels der Anzeigeeinheit 7 kann ein Benutzer auf das Auftretens eines entsprechenden Erd-Fehlerstromes hingewiesen werden. Dabei kann weiters, ja nach Art der Anzeigeeinheit 7 auch Auskunft über die Stärke des Erd-Fehlerstromes ausgegeben werden, sowie der Hinweis ärztliche Hilfe zu suchen.

Der Detektor 1 weist bevorzugt wenigstens eine Schnittstelle 8 auf, welche mit der Vergleichs- und Entscheidungseinheit 4 verbunden ist. Mittels der Schnittstelle 8 können die ermittelten Daten an eine Kontrollstelle übermittelt werden oder aber ein elektronisch ansteuerbares Schaltgerät 10 ausgelöst werden. Bevorzugt ist die Schnittstelle 8 als elektronische Datenübertragungsschnittstelle ausgebildet.

Gemäß einer weiteren bevorzugten Ausführungsform ist die Schnittstelle 8 als mechanische Schnittstelle 9 zur mechanischen Auslösung eines Schaltgeräts 10 ausgebildet. Bei Ausbildung der Schnittstelle 8 als mechanische Schnittstelle 9 weist der Detektor ein elektromechanisches Betätigungsglied auf, um auf ein angekoppeltes Schaltgerät 10 einzuwirken. Zahlreiche Schutzschaltgeräte, bzw. Selbstschalter weisen an deren Gehäuseseitenwänden entsprechende Schnittstellen zur Koppelung mit einem Anbaugerät auf.

Die Fig. 2 und 3 zeigen jeweils Ausführungsformen eines Schaltgeräts 10 mit einem gegenständlichen Detektor 1, wobei die Schnittstelle 8, 9 zum Abschalten des Schaltgeräts 10 mit einem Auslöser 11 das Schaltgeräts 10 verbunden ist. Die entsprechende Schnittstelle 8 ist dabei bei der Ausführungsform gemäß Fig. 3 nicht dargestellt, da dabei der Detektor lediglich als Blockschaltbild dargestellt ist, welche direkt mit der Processing-Einheit verbunden ist.

Ein gegenständlicher Detektor 1 führt dabei ein Verfahren durch, um einen Erd-Fehlerstrom als einen solchen zu erkennen, welcher durch einen Menschen oder ein Nutztier verursacht wurde. Nachfolgend wird ein bevorzugter Verfahrensablauf beschrieben, wobei nicht zwingend bei sämtlichen Ausführungen des Verfahrens bzw. des Detektors sämtliche Verfahrensschritte durchgeführt werden müssen. So sind beispielsweise Verfahrensschritte, welche sich auf die Aufnahme eines bestimmten Messwerts beziehen nur bei Ausführungen eines Detektors 1 vorgesehen, welcher über eine entsprechende Messanordnung 2, 3, 5 verfügt.

Bei dem gegenständlichen Verfahren wird von der Spannungsmessanordnung 2 eine an dem elektrischen Kreis anliegende Netzspannung gemessen, und ein entsprechender Messwert erstellt. Von der Erd-Fehlerstrommessanordnung 3 wird das Netz auf das Auftreten eines Erd-Fehlerstroms überwacht. Bei Auftreten eines Erd-Fehlerstroms wird der Wert des Erd-Fehlerstroms durch die Erd-Fehlerstrommessanordnung 3 gemessen.

Die Phasen-Messanordnung 5 misst den Phasenwinkel zwischen der Versorgungsspannung und dem Erd-Fehlerstrom.

Aus den Werten für die Netzspannung, den Erd-Fehlerstrom sowie den Phasenwinkel wird ein komplexer Wert für die Erd/Fehlerstrom-Impedanz ermittelt, welcher an die Vergleichs- und Entscheidungseinheit 4 geschickt wird.

Bei einer einfachen Ausführung des gegenständlichen Verfahrens wird der derart ermittelte Wert für die Erd/Fehlerstrom-Impedanz mit einer entsprechenden Erd/Fehlerstrom-Impedanz-Grenzbedingung verglichen.

Gemäß der bevorzugten Ausführungsform des gegenständlichen Verfahrens ist vorgesehen, dass
- in einem ersten Schritt eine Ausgangsspannung des Detektors 1 von einer Spannungsanpassungseinheit 16 auf einen ersten Spannungswert kleiner 10% der Versorgungsspannung abgesenkt wird, bei, gegenüber der Versorgungsspannung, unveränderter Frequenz der Ausgangsspannung,
- in einem zweiten Schritt die Ausgangsspannung von der Spannungsanpassungseinheit 16 auf dem ersten Spannungswert belassen wird, und die Frequenz der Ausgangsspannung von der Spannungsanpassungseinheit 16 gegenüber einer Frequenz der Versorgungsspannung verdoppelt wird,
- in einem dritten Schritt, bei, gegenüber der Versorgungsspannung verdoppelter Frequenz, die Ausgangsspannung von der Spannungsanpassungseinheit 16 auf einen zweiten Spannungswert zwischen 25% und 50% der Versorgungsspannung eingestellt wird, und
- in einem vierten Schritt die Ausgangsspannung von der Spannungsanpassungseinheit 16 auf dem zweiten Spannungswert belassen wird, und die Frequenz der Ausgangsspannung von der Spannungsanpassungseinheit 16 an die Frequenz der Versorgungsspannung angeglichen wird.

Wie bereits dargelegt, können die jeweiligen Schritte auch in unterschiedlicher Reihen folge durchgeführt werden, wobei jeweils einer noch nicht ausgeführten Schritte nachfolgend einem bereits ausgeführten Schritt durchgeführt wird.

Nach der Veränderung der Ausgangsspannung wird jeweils die Erd/Fehlerstrom-Impedanz gemessen bzw. ermittelt.

Zwischen der Veränderung der Ausgangsspannung und der Messwertaufnahme ist vorgesehen eine vorgebbare Zeitspanne abzuwarten, um dem Netz Zeit zum einschwingen zu geben. Bevorzugt ist dabei vorgesehen, dass dabei 1 Millisekunde gewartet wird.

Es kann vorgesehen sein, jeden der derart ermittelten vier Erd/Fehlerstrom-Impedanzen jeweils mit einer Erd/Fehlerstrom-Impedanz-Grenzbedingung zu vergleichen. Bevorzugt ist jedoch vorgesehen, die betreffenden Werte, wie bereits dargelegt zu Verhältniszahlen zu dividieren.

Bei Erfüllen der Grenzbedingungen durch den Erd-Fehlerstrom, wird dieser von der Vergleichs- und Entscheidungseinheit 4 als menschenverursachter Erd-Fehlerstrom erkannt, und dieses Ergebnis weitergemeldet. Entsprechend wird nachfolgend eine Meldung abgesetzt und etwa angezeigt, bzw. ein Schaltgerät ausgelöst.

## Patentansprüche

1. Detektor (1) zum Erkennen eines Erd/Fehlerstromes als durch einen Menschen und/oder ein vorgebbares Nutztier verursachten Erd/Fehlerstrom innerhalb eines elektrischen Kreises, wobei der Detektor (1) wenigstens eine Erd/Fehlerstrom-Impedanzmessanordnung (15) aufweist, wobei die Erd/Fehlerstrom-Impedanzmessanordnung (15) eine Spannungsmessanordnung (2) zum Messen einer Versorgungsspannung aufweist, welche Versorgungsspannung an dem Detektor (1) anliegt, wobei der Detektor (1) eine Vergleichs- und Entscheidungseinheit (4) aufweist, welche Vergleichs- und Entscheidungseinheit (4) mit der Impedanzmessanordnung (2) verbunden ist, wobei die Vergleichs- und Entscheidungseinheit (4) dazu ausgebildet ist, ermittelte Werte der Erd/Fehlerstrom-Impedanz mit wenigstens einer vorgebbaren Erd/Fehlerstrom-Impedanz-Grenzbedingung zu vergleichen, wobei die Vergleichs- und Entscheidungseinheit (4) weiters dazu ausgebildet ist, den Erd/Fehlerstrom als menschenverursachten Erd/Fehlerstrom auszugeben, wobei zur Ausgabe des Erd-Fehlerstroms als menschenverursachten Erd-Fehlerstrom die Erd/Fehlerstrom-Impedanz die wenigstens eine Erd/Fehlerstrom-Impedanz-Grenzbedingung erfüllen muss, wobei der Detektor eine Spannungsanpassungseinheit (16) zur vorgebbaren Anpassung, insbesondere Absenkung, einer Ausgangsspannung des Detektors (1) gegenüber der Versorgungsspannung aufweist, wobei die Spannungsanpassungseinheit (16) zur vorgebbaren Anpassung, insbesondere zur Verdoppelung, einer Frequenz der Ausgangsspannung gegenüber der Versorgungsspannung ausgebildet ist, **dadurch gekennzeichnet, dass** die Spannungsanpassungseinheit (16) dazu ausgebildet ist,
- in einem ersten Schritt die Ausgangsspannung auf einen ersten Spannungswert kleiner 10% der Versorgungsspannung abzusenken, bei, gegenüber der Versorgungsspannung, unveränderter Frequenz der Ausgangsspannung,
- in einem zweiten Schritt die Ausgangsspannung auf dem ersten Spannungswert zu belassen, und die Frequenz der Ausgangsspannung gegenüber der Versorgungsspannung zu verdoppeln,
- in einem dritten Schritt, bei, gegenüber der Versorgungsspannung verdoppelter Frequenz, die Ausgangsspannung auf einen zweiten Spannungswert zwischen 25% und 50% der Versorgungsspannung einzustellen, und
- in einem vierten Schritt die Ausgangsspannung auf dem zweiten Spannungswert zu belassen, und die Frequenz der Ausgangsspannung an die Frequenz der Versorgungsspannung anzugleichen.

2. Detektor (1) nach Anspruch 1, **dadurch gekennzeichnet, dass** die Erd/Fehlerstrom-Impedanzmessanordnung (15) eine Erd/Fehlerstrommessanordnung (3) zum Messen des Erd/Fehlerstromes aufweist.

3. Detektor (1) nach Anspruch 2, **dadurch gekennzeichnet, dass** die Erd/Fehlerstrom-Impedanzmessanordnung (15) eine Phasen-Messanordnung (5) zum Ermitteln eines Phasenwinkels zwischen der Versorgungsspannung und dem Erd/Fehlerstrom aufweist, dass die Vergleichs- und Entscheidungseinheit (4) mit der Phasen-Messanordnung (5) verbunden ist, und dass die Vergleichs- und Entscheidungseinheit (4) dazu ausgebildet ist den Phasenwinkel mit wenigstens einer Phasenwinkel-Grenzbedingung zu vergleichen, und dass zur Ausgabe des Erd/Fehlerstroms als menschenverursachten Erd/Fehlerstrom weiters der Phasenwinkel die Phasenwinkel-Grenzbedingung erfüllen muss.

4. Detektor (1) nach einem der Ansprüche 1 bis 3, **dadurch gekennzeichnet, dass** der Detektor (1) eine Uhr (6) zum Messen der Dauer des auftretenden Erd/Fehlerstromes aufweist, dass die Vergleichs- und Entscheidungseinheit (4) mit der Uhr (6) verbunden ist, und dass die Vergleichs- und Entscheidungseinheit (4) dazu ausgebildet ist, die Dauer des Erd/Fehlerstromes mit wenigstens einer vorgebbaren Zeit-Grenzbedingung zu vergleichen, und bei Überschreiten der wenigstens einen Zeit-Grenzbedingung durch einen menschen- oder nutztierverursachten Erd/Fehlerstrom diesen als für den Menschen bzw. das Nutztier gefährlichen Erd/Fehlerstrom auszugeben.

5. Verfahren zum Erkennen eines Erd/Fehlerstromes als durch einen Menschen und/oder ein vorgebbares Nutztier verursachter Erd-Fehlerstrom innerhalb eines elektrischen Kreises, wobei mittels einer Erd/Fehlerstrom-Impedanzmessanordnung (15) ein Wert einer Erd/Fehlerstrom-Impedanz ermittelt wird, wobei die Erd/Fehlerstrom-Impedanzmessanordnung (15) eine Spannungsmessanordnung (2) zum Messen einer Versorgungsspannung aufweist, welche Versorgungsspannung an dem Detektor (1) anliegt, wobei der Wert der Erd/Fehlerstrom-Impedanz von einer Vergleichs- und Entscheidungseinheit (4) mit wenigstens einer vorgebbaren Erd/Fehlerstrom-Impedanz-Grenzbedingungen verglichen wird, wobei zur Ausgabe des Erd/Fehlerstroms als menschenverursachten Erd/Fehlerstrom durch die Vergleichs- und Entscheidungseinheit (4) die Erd/Fehlerstrom-Impedanz die wenigstens eine Erd/Fehlerstrom-Impedanz-Grenzbedingung erfüllen muss, **dadurch gekennzeichnet, dass**
- in einem ersten Schritt eine Ausgangsspannung des Detektors (1) von einer Spannungsanpassungseinheit (16) auf einen ersten Spannungswert kleiner 10% der Versorgungsspannung abgesenkt wird, bei, gegenüber der Versorgungsspannung, unveränderter Frequenz der Ausgangsspannung,
- in einem zweiten Schritt die Ausgangsspannung von der Spannungsanpassungseinheit (16) auf dem ersten Spannungswert belassen wird, und die Frequenz der Ausgangsspannung von der Spannungsanpassungseinheit (16) gegenüber einer Frequenz der Versorgungsspannung verdoppelt wird,
- in einem dritten Schritt, bei, gegenüber der Versorgungsspannung verdoppelter Frequenz, die Ausgangsspannung von der Spannungsanpassungseinheit (16) auf einen zweiten Spannungswert zwischen 25% und 50% der Versorgungsspannung eingestellt wird, und
- in einem vierten Schritt die Ausgangsspannung von der Spannungsanpassungseinheit (16) auf dem zweiten Spannungswert belassen wird, und die Frequenz der Ausgangsspannung von der Spannungsanpassungseinheit (16) an die Frequenz der Versorgungsspannung angeglichen wird.

6. Verfahren nach Anspruch 5, **dadurch gekennzeichnet, dass** zur Ermittlung der Erd/Fehlerstrom-Impedanz eine Versorgungsspannung von einer Spannungsmessanordnung (2) der Erd/Fehlerstrom-Impedanzmessanordnung (15) gemessen wird, dass ein Erd/Fehlerstrom von einer Erd/Fehlerstrommessanordnung (3) der Erd/Fehlerstrom-Impedanzmessanordnung (15) gemessen wird, wobei der Phasenwinkel zwischen der Versorgungsspannung und dem Erd/Fehlerstrom von einer Phasen-Messanordnung (5), welche Teil der Erd/Fehlerstrom-Impedanzmessanordnung (15) ist, gemessen wird, und dass die Erd/Fehlerstrom-Impedanz von der Erd/Fehlerstrom-Impedanzmessanordnung (15) aus der gemessenen Versorgungsspannung und dem gemessenen Erd/Fehlerstrom, sowie dem Phasenwinkel, ermittelt wird.

## Claims

1. Detector (1) for recognising a ground/fault current as a ground/fault current caused by a human and/or a predeterminable farm animal within an electrical circuit, wherein the detector (1) has at least one ground/fault current impedance measurement arrangement (15), wherein the ground/fault current impedance measurement arrangement (15) has a voltage measurement arrangement (2) for measuring a supply voltage, which supply voltage is applied to the detector (1), wherein the detector (1) has a comparison and decision-making unit (4), which comparison and decision-making unit (4) is connected to the impedance measurement arrangement (2), wherein the comparison and decision-making unit (4) is designed to compare determined values of ground/fault current impedance to at least one predeterminable ground/fault current impedance limit condition, wherein the comparison and decision-making unit (4) is furthermore designed to output the ground/fault current as human-caused ground/fault current, wherein the ground/fault current impedance must fulfil the at least one ground/fault current impedance limit condition in order for the ground-fault current to be output as human-caused ground-current current, wherein the detector has a voltage adjustment unit (16) for the predeterminable adjustment, in particular lowering, of an output voltage of the detector (1) relative to the supply voltage, wherein the voltage adjustment unit (16) is designed for the predeterminable adjustment, in particular, for doubling a frequency of the output voltage relative to the supply voltage, **characterised in that** the voltage adjustment unit (16) is designed,
- in a first step to lower the output voltage to a first voltage value less than 10% of the supply voltage, when the frequency of the output voltage is unchanged relative to the supply voltage,
- in a second step to leave the output voltage at the first voltage value, and to double the frequency of the output voltage relative to the supply voltage,
- in a third step, when the frequency is doubled relative to the supply voltage, to set the output voltage to a second voltage value between 25% and 50% of the supply voltage, and
- in a fourth step to leave the output voltage at the second voltage value, and to adapt the frequency of the output voltage to the frequency of the supply voltage.

2. Detector (1) according to claim 1, **characterised in that** the ground/fault current impedance measurement arrangement (15) has a ground/fault current measurement arrangement (3) for measuring the ground/fault current.

3. Detector (1) according to claim 2, **characterised in that** the ground/fault current impedance measurement arrangement (15) has a phase measurement arrangement (5) for determining a phase angle between the supply voltage and the ground/fault current, that the comparison and decision-making unit (4) is connected to the phase measurement arrangement (5), and that the comparison and decision-making unit (4) is designed to compare the phase angle with at least one phase angle limit condition, and that furthermore the phase angle must fulfil the phase angle limit condition in order for the ground-fault current to be output as human-caused ground/current.

4. Detector (1) according to any one of claims 1 to 3, **characterised in that** the detector (1) has a clock (6) for measuring the duration of the current that occurs, that the comparison and decision-making unit (4) is connected to the clock (6), and that the comparison and decision-making unit (4) is designed to compare the duration of the ground/fault current with at least one predeterminable time limit condition, and when the at least one time limit condition is exceeded by a human- or farm animal-caused ground/fault current to output the latter as a ground/fault current hazardous for the human or the farm animal.

5. Method for recognising a ground/fault current as a ground-fault current caused by a human and/or a predeterminable farm animal within an electrical circuit, wherein a value of a ground/fault current impedance is determined by means of a ground/fault current impedance measurement arrangement (15), wherein the ground/fault current impedance measurement arrangement (15) has a voltage measurement arrangement (2) for measuring a supply voltage, which supply voltage is applied to the detector (1), wherein the value of the ground/fault current impedance is compared by a comparison and decision-making unit (4) with at least one of the predeterminable ground/fault current impedance limit conditions, wherein the ground/fault current impedance must fulfil at least one ground/fault current impedance limit condition in order for the ground/fault current to be output as human-caused ground/fault current by the comparison and decision-making unit (4), **characterised in that**
- in a first step an output voltage of the detector (1) is lowered by a voltage adjustment unit (16) to a first voltage value less than 10% of the supply voltage, when the frequency of the output voltage is unchanged relative to the supply voltage,
- in a second step the output voltage is left by the voltage adjustment unit (16) at the first voltage value, and the frequency of the output voltage is doubled by the voltage adjustment unit (16) relative to a frequency of the supply voltage,
- in a third step, when the frequency is doubled relative to the supply voltage, the output voltage is set by the voltage adjustment unit (16) to a second voltage value between 25% and 50% of the supply voltage, and
- in a fourth step the output voltage is left by the voltage adjustment unit (16) at the second voltage value, and the frequency of the output voltage is adapted by the voltage adjustment unit (16) to the frequency of the supply voltage.

6. Method according to claim 5, **characterised in that** in order to determine the ground/fault current impedance a supply voltage is measured by a voltage measurement arrangement (2) of the ground/fault current impedance measurement arrangement (15), that a ground/fault current is measured by a ground/fault current measurement arrangement (3) of the ground/fault current impedance measurement arrangement (15), wherein the phase angle between the supply voltage and the ground/fault current is measured by a phase measurement arrangement (5), which is part of the ground/fault current impedance measurement arrangement (15), and that the ground/fault current impedance is determined by the ground/fault current impedance measurement arrangement (15) from the measured supply voltage and the measured ground/fault current and the phase angle.

## Revendications

1. Détecteur (1) destiné à la détection d'un courant de fuite/perte en tant que courant de fuite/perte provoqué par une personne et/ou par un animal de ferme prédéfini à l'intérieur d'un circuit électrique, le détecteur (1) présentant au moins un dispositif de mesure d'impédance de courant de fuite/perte (15), le dispositif de mesure d'impédance de courant de fuite/perte (15) présentant un dispositif de mesure de tension (2) pour mesurer une tension d'alimentation, laquelle tension d'alimentation est appliquée au détecteur (1), le détecteur (1) présentant une unité de comparaison et de décision (4), laquelle unité de comparaison et de décision (4) est connectée au dispositif de mesure d'impédance (2), l'unité de comparaison et de décision (4) étant conçue pour comparer des valeurs déterminées de l'impédance de courant de fuite/perte avec au moins une condition limite d'impédance de courant de fuite/perte pouvant être prédéfinie, l'unité de comparaison et de décision (4) étant en outre conçue pour délivrer le courant de fuite/perte comme courant de fuite/perte d'origine humaine, dans lequel, pour délivrer le courant de fuite/perte comme courant de fuite/perte d'origine humaine, l'impédance de courant de fuite/perte doit remplir l'au moins une condition limite d'impédance de courant de fuite/perte, le détecteur présentant une unité d'adaptation de tension (16) pour une adaptation, en particulier une réduction, pouvant être prédéfinie d'une tension de sortie du détecteur (1) par rapport à la tension d'alimentation, l'unité d'adaptation de tension (16) étant conçue pour une adaptation, en particulier pour un doublement, pouvant être prédéfinie d'une fréquence de la tension de sortie par rapport à la tension d'alimentation, **caractérisé en ce que** l'unité d'adaptation de tension (16) est conçue pour,
- dans une première étape, réduire la tension de sortie à une première valeur de tension inférieure à 10 % de la tension d'alimentation, la fréquence de la tension de sortie restant inchangée par rapport à la tension d'alimentation,
- dans une deuxième étape, laisser la tension de sortie à la première valeur de tension et doubler la fréquence de la tension de sortie par rapport à la tension d'alimentation,
- dans une troisième étape, à une fréquence double de celle de la tension d'alimentation, régler la tension de sortie à une deuxième valeur de tension comprise entre 25 et 50 % de la tension d'alimentation, et
- dans une quatrième étape, laisser la tension de sortie à la deuxième valeur de tension et ajuster la fréquence de la tension de sortie à la fréquence de la tension d'alimentation.

2. Détecteur (1) selon la revendication 1, **caractérisé en ce que** le dispositif de mesure d'impédance de courant de fuite/perte (15) présente un dispositif de mesure de courant de fuite/perte (3) pour mesurer le courant de fuite/perte.

3. Détecteur (1) selon la revendication 2, **caractérisé en ce que** le dispositif de mesure d'impédance de courant de fuite/perte (15) présente un dispositif de mesure de phase (5) pour déterminer un angle de phase entre la tension d'alimentation et le courant de fuite/perte, **en ce que** l'unité de comparaison et de décision (4) est connectée au dispositif de mesure de phase (5), et **en ce que** l'unité de comparaison et de décision (4) est conçue pour comparer l'angle de phase avec au moins une condition limite d'angle de phase, et **en ce que**, pour produire le courant de fuite/perte comme courant de fuite/perte d'origine humaine, l'angle de phase doit en outre remplir la condition limite d'angle de phase.

4. Détecteur (1) selon l'une quelconque des revendications 1 à 3, **caractérisé en ce que** le détecteur (1) présente une horloge (6) pour mesurer la durée du courant de fuite/perte se produisant, **en ce que** l'unité de comparaison et de décision (4) est connectée à l'horloge (6) et **en ce que** l'unité de comparaison et de décision (4) est conçue pour comparer la durée du courant de fuite/perte avec au moins une condition limite de temps pouvant être prédéfinie et, si cette au moins une condition limite de temps est dépassée par un courant de fuite/perte d'origine humaine ou animale, pour désigner celui-ci comme courant de fuite/perte nocif pour l'homme ou les animaux.

5. Procédé de détection d'un courant de fuite/perte comme courant de fuite/perte d'origine humaine et/ou animale pouvant être prédéfini au sein d'un circuit électrique, une valeur d'une impédance de courant de fuite/perte étant déterminée au moyen d'un dispositif de mesure d'impédance de courant de fuite/perte (15), le dispositif de mesure d'impédance de courant de fuite/perte (15) présentant un dispositif de mesure de tension (2) pour mesurer une tension d'alimentation, laquelle tension d'alimentation est appliquée au détecteur (1), la valeur de l'impédance de courant de fuite/perte étant comparée par une unité de comparaison et de décision (4) à au moins une condition limite d'impédance de courant de fuite/perte pouvant être prédéfinie, dans lequel, pour la désignation du courant de fuite/perte comme courant de fuite/perte d'origine humaine par l'unité de comparaison et de décision (4), l'impédance de courant de fuite/perte doit remplir l'au moins une condition limite d'impédance de courant de fuite/perte, **caractérisé en ce que**
- dans une première étape, une tension de sortie du détecteur (1) est réduite par une unité d'adaptation de tension (16) à une première valeur de tension inférieure à 10 % de la tension d'alimentation, la fréquence de la tension de sortie restant inchangée par rapport à la tension d'alimentation,
- dans une deuxième étape, la tension de sortie de l'unité d'adaptation de tension (16) est laissée à la première valeur de tension et la fréquence de la tension de sortie de l'unité d'adaptation de tension (16) est doublée par rapport à une fréquence de la tension d'alimentation,
- dans une troisième étape, à une fréquence double de celle de la tension d'alimentation, la tension de sortie est ajustée par l'unité d'adaptation de tension (16) à une deuxième valeur de tension comprise entre 25 % et 50 % de la tension d'alimentation, et
- dans une quatrième étape, la tension de sortie de l'unité d'adaptation de tension (16) est laissée à la deuxième valeur de tension et la fréquence de la tension de sortie de l'unité d'adaptation de tension (16) est ajustée à la fréquence de la tension d'alimentation.

6. Procédé selon la revendication 5, **caractérisé en ce que**, pour déterminer l'impédance de courant de fuite/perte, une tension d'alimentation est mesurée par un dispositif de mesure de tension (2) du dispositif de mesure d'impédance de courant de fuite/perte (15), **en ce qu'**un courant de fuite/perte est mesuré par un dispositif de mesure de courant de fuite/perte (3) du dispositif de mesure d'impédance de courant de fuite/perte (15), l'angle de phase entre la tension d'alimentation et le courant de fuite/perte étant mesuré par un dispositif de mesure de phase (5) qui fait partie du dispositif de mesure d'impédance de courant de fuite/perte (15), et **en ce que** l'impédance de courant de fuite/perte est déterminée par le dispositif de mesure d'impédance de courant de fuite/perte (15) à partir de la tension d'alimentation mesurée et du courant de fuite/perte mesuré, ainsi que de l'angle de phase.
